# EUROPÄISCHE PATENTSCHRIFT

(11) **EP 2 609 795 B1**
(45) Veröffentlichungstag und Bekanntmachung des Hinweises auf die Patenterteilung: **14.10.2015**
(21) Anmeldenummer: 11745779.6
(22) Anmeldetag: 18.08.2011
(51) Int. Cl.: H05K 7/20, H05K 1/02, H05K 3/30

(54) **VERFAHREN ZUR BESTÜCKUNG EINER LEITERPLATTE MIT MEHREREN BAUTEILEN UND ELEKTRISCHE SCHALTUNG MIT EINER LEITERPLATTE UND DARAUF MONTIERTEN MEHREREN BAUTEILEN**
METHOD FOR POPULATING A CIRCUIT BOARD WITH A PLURALITY OF COMPONENTS AND ELECTRICAL CIRCUIT HAVING A CIRCUIT BOARD AND A PLURALITY OF COMPONENTS MOUNTED THEREON
PROCÉDÉ POUR IMPLANTER PLUSIEURS COMPOSANTS SUR UNE CARTE DE CIRCUIT ET CIRCUIT ÉLECTRIQUE COMPORTANT UNE CARTE DE CIRCUIT SUR LAQUELLE SONT IMPLANTÉS PLUSIEURS COMPOSANTS

(30) Priorität: 25.08.2010 DE 102010039749
(43) Veröffentlichungstag der Anmeldung: 03.07.2013
(73) Patentinhaber: Robert Bosch GmbH, 70442 Stuttgart (DE)
(72) Erfinder: HESS, Gottfried, 72793 Pfullingen (DE)
(86) Internationale Anmeldenummer: PCT/EP2011/064197
(87) Internationale Veröffentlichungsnummer: WO 2012/025446

(56) Entgegenhaltungen:
- DE-A1- 10 259 277
- DE-U1- 20 320 779
- US-A- 3 766 439
- US-A- 5 661 902

## Beschreibung

### Stand der Technik

Bauteile elektrischer Schaltungen werden üblicherweise mittels einer Leiterplatte elektrisch miteinander verbunden, die ebenso die Bauteile mechanisch zueinander anordnet. Es bestehen zahlreiche Normen, die die Geometrie der Bauelemente-Packages definieren, d.h., Anordnung und Größe von Anschlüssen der Bauteile sowie deren Länge und Breite, wobei jedoch die Bauteilhöhe stärkeren Schwankungen bzw. Toleranzen unterliegt, da sie bei herkömmlicher Montage der Bauelemente nicht relevant ist.

Zahlreiche Bauteile, insbesondere Leistungs-Bauteile und mit hoher Taktzahl betriebene Prozessoren und Speicher, erzeugen Wärme, die über zusätzliche Kühlkörper abgeführt werden muss. Insbesondere bei der sogenannten Slug-up-Bauweise werden zu kühlende Bauteile mit Kühlflächen ausgestattet, die auf der zur Leiterplatte entgegengesetzten Seite liegen, und die an einen Kühlkörper angedrückt werden.

Es ergibt sich bei elektrischen Schaltungen mit mehreren zu kühlenden Bauteilen das Problem, dass ein gemeinsamer Kühlkörper erfordert, dass alle Kühlflächen in der gleichen Ebene liegen. Jedoch haben Bauteile unterschiedlichen Typs und auch gleichartige Bauteile aufgrund von Fertigungstoleranzen unterschiedliche Höhen bzw. Dicken, welche zu einem stark reduzierten Wärmekontakt zum Kühlkörper führen können. Die Verwendung eines Wärmeleitmediums zum Ausgleich der unterschiedlichen Höhen löst das Problem nur unvollständig, da der Wärmewiderstand mit zunehmender Spaltdicke größer wird, und sich somit die Entwärmung des Bauelements verschlechtert.

In der Druckschrift DE 296 09 183 U1 ist eine Halterung für elektronische Bauteile beschrieben, bei der Andrucknoppen elastisch verformt werden, um mit einem Kühlelement einen Gegendruck zu erzeugen, wodurch die elektronischen Bauteile in einem Presssitz gehalten werden. Zum einen werden Bauteile mit geringerer Höhe nur geringfügig (wenn überhaupt) angepresst, so dass der Wärmekontakt für diese Bauteile stark fehleranfällig ist und Vibrationen das weniger stark angepresste Bauteil leicht verschieben können, und zum anderen ist ein präzises Gegenlager zur Erzeugung einer hohen (da summierten) Gegenkraft notwendig, von dessen Funktion die Lagerung aller Bauteile abhängt. Schließlich erzeugt diese Art von Halterung notwendigerweise durchgehend eine mechanische Spannung in den Bauteilen (insbesondere eine stark erhöhte Spannung in den dickeren Bauteilen) und vielmehr noch in den Lötstellen, wobei dies insbesondere bei kleineren Packagingvarianten die Lebensdauer der Bauteile beeinträchtigt und deren Fehleranfälligkeit sowie das Risiko der Lötstellenzerrüttung bei zusätzlichen mechanischen Belastungen (Vibrationen, Stoßbelastung) signifikant erhöht. Außerdem besteht die Gefahr, dass die Leiterplatte durch die Kräfte durchgebogen wird, und infolgedessen andere elektrische/elektronische Bauteile, z.B. Keramikkondensatoren, brechen können.

Es ist daher eine Aufgabe der Erfindung, eine elektrische Schaltung und ein Verfahren zu deren Herstellung vorzusehen, mit der bzw. dem auf einfache Weise mehrere zu kühlende Bauteile mit gleichmäßigerem, stabilerem und verbessertem Wärmekontakt zu einem Kühlelement bei geringerer Fehleranfälligkeit vorgesehen werden, ohne dabei Spannungen in den Lötstellen zu erzeugen.

Aus der Druckschrift DE 102 59 277 A1 (vergl. dem Oberbegriff der unabhängige Ansprüche) ist eine Anordnung und ein Verfahren zur Fixierung eines elektronischen THT-Bauelements mit Anschlussdrähten, die durch Kontaktöffnungen einer Leiterplatte gesteckt und dort verlötet werden, bekannt. Während des Lötvorgangs wird dabei eine Box über ein auf einer Leiterplatte angeordnetes Bauelement gestülpt. Im Inneren der Box ist ein federndes Fixierelement angeordnet, das einen definierten Abstand zwischen dem Bauelement und der Leiterplatte einstellt.

Aus der Druckschrift US 3 766 439 A ist eine Anordnung zur Herstellung eines mehrlagigen Schaltungsträgers bekannt. Eine mit auf ihrer Oberfläche kontaktierten elektronischen Bauelementen bestückte flexible Leiterplatte wird mehrfach gefaltet und in eine Gehäusestruktur verpackt. Zur verbesserten Wärmeableitung sind die der Leiterplatte abgewandten Flächen der elektronischen Bauelemente durch flexible Abstandshalter an wärmeableitende Flächen der Gehäusestruktur angepresst.

### Offenbarung der Erfindung

Diese Aufgabe wird gelöst durch das Verfahren und die elektrische Schaltung der unabhängigen Ansprüche.

Die Erfindung ermöglicht auf sehr einfache Weise eine Kompensation unterschiedlicher Bauteildicken bei Montage eines gemeinsamen Kühlelements und eine gleichmäßige Druckverteilung. Die Erfindung ermöglicht ferner die Anordnung aller Wärmeabgabeflächen der Bauteile in der gleichen Höhe (in der gleichen Ebene), die auch bei spannungsfreier Anordnung der Bauteile fortbesteht. Für diese Anordnung wird daher kein spezifisches Federelement benötigt. Vielmehr kompensiert das Fixierelement die unterschiedlichen Dicken, wobei diese Kompensation nicht mit unerwünschten, unterschiedlichen Druckbeaufschlagungen verknüpft ist. Die Kompensation wird mit kostengünstigen Mitteln erreicht und sieht eine Lagerung und Kühlung der Bauteile vor, die resistent gegenüber Stoß- und Vibrationsbeeinflussung ist, für jedes Bauteil einen genau dosierten Presssitz vorsieht, und daher eine hohe Lebensdauer und mechanische Belastbarkeit der erzeugten elektrischen Schaltung ermöglicht.

Gemäß einem allgemeinen Aspekt der Erfindung wird zum Ausgleichen unterschiedlicher Bauteilhöhen ein plastisch verformbares Fixierelement verwendet. Die gewünschte Anordnung von Wärmeabgabeflächen der zu kühlenden Bauteile wird von einer Oberfläche vorgegeben, mit der die Wärmeabgabeflächen fluchtend miteinander ausgerichtet werden, und die die Bauteile bei diesem Ausrichtvorgang zur Leiterplatte hin bewegt. Zwischen Leiterplatte und Bauteil sind elastisch verformbare Fixierelemente vorgesehen, die durch plastische Verformung die zur Leiterplatte hin gerichtete Bewegung der Bauteile aufnehmen. Dadurch kompensieren die Fixierelemente durch ihre Verformung unterschiedliche Bauteildicken bzw. Bauteilhöhen. Damit die elektrischen Verbindungen zwischen Bauteil und Leiterplatte die unterschiedlichen, kompensierten Abstände zwischen Bauteil und Leiterplatte (entsprechend der jeweiligen Dicke der verformten Fixierelemente) überbrücken können, werden die Bauteile mittels Durchsteckmontage mit der Leiterplatte elektrisch verbunden. Da die Durchsteckkontakte (oder zumindest deren Endabschnitte) im Wesentlichen senkrecht zu der Leiterplatte verlaufen, und somit parallel zu der Verschiebungsrichtung der Bauteile (=Verformungsrichtung der plastisch verformbaren Fixierelemente) sind, kompensieren die Durchsteckkontakte die Bewegung des Bauteils, indem diese sich gemäß der Verschiebung des Bauteils durch die zugehörigen Kontaktlöcher in der Leiterplatte hindurch bewegen (oder zunächst auf diese zu und in diese hinein bewegen).

Die Kombination von Durchsteckmontage und Kompensation durch plastische Verformung des Fixierelements ermöglicht eine vollkommen spannungsfreie Anordnung der Bauelemente und der späteren Lötstellen, um die Wärmeabgabenflächen zueinander fluchtend auszurichten. Eine Oberfläche drückt und verschiebt die Bauelemente in die Fixierelemente hinein, bis alle betreffenden Wärmeabgabenflächen in der gleichen Ebene sind (oder bis ein vorgegebener Abstand, beispielsweise mittels eines Abstandhalters, zwischen Wärmeabgabeflächen und Leiterplatte erreicht ist). Auf diese Ebene (definiert durch die Oberfläche) lässt sich auf einfache Weise und spannungsfrei ein Kühlelement montieren, das ebenso eine ebene Wärmeaufnahmefläche aufweist. Insbesondere ist gewährleistet, dass trotz unterschiedlicher Bauteildicken bei Presssitzmontage des Kühlelements alle Wärmeabgabeflächen mit dem gleichen Druck gegen das Kühlelement gepresst werden, wodurch der Wärmekontakt für alle Wärmeabgabeflächen gleich ist. Eine Kontaktlücke durch mangelnde Anpresskraft wird durch die Erfindung ausgeschlossen.

Die Oberfläche, gebildet von einem Anordnungskörper (aus einem Feststoff), gibt eine Zielebene vor, entlang der die Wärmeabgabenflächen verlaufen sollen. Da zahlreiche Kühlelemente eine ebene Wärmeaufnahmefläche aufweisen, weist die Oberfläche ebenso einen ebenen Verlauf auf. Es ist jedoch auch möglich, die Wärmeabgabeflächen der Bauteile gemäß einem beliebigen gewünschten (insbesondere nicht ebenen) Verlauf anzuordnen, wobei die Oberfläche des Anordnungskörpers, mit dem die Bauteile verschoben werden, dem Oberflächenverlauf eines anzuordnenden Kühlkörpers entspricht, und die Wärmeabgabeflächen durch Anwendung eines Anordnungskörpers mit einem Verlauf angeordnet werden, der komplementär zum Oberflächenverlauf des anzuordnenden Kühlkörpers (=Verlauf der Oberfläche des Anordnungskörpers) ist.

Die Erfindung betrifft daher ein Verfahren zur Bestückung einer Leiterplatte mit mehreren Bauteilen, wobei die Bauteile mit Durchsteckkontakten versehen sind, die sich zumindest in den Endabschnitten der Durchsteckkontakte in einer Richtung senkrecht zu den Wärmeabgabenflächen der Bauteile erstrecken. Dies wird erreicht durch Verwendung von Bauelementen, die diese Eigenschaft fertigungsbedingt aufweisen, oder von Bauelementen, deren Durchsteckkontakte in dieser Weise gebogen werden. Ferner wird die Leiterplatte mit Kontaktlöchern zur Aufnahme von Durchsteckkontakten (d.h. Drähten) versehen, beispielsweise durch Bohren. Erfindungsgemäß wird mindestens ein plastisch verformbares Fixierelement auf die Leiterplatte aufgebracht. Das Fixierelement wird beispielsweise durch eine Haftverbindung mit der Leiterplatte verbunden, wobei vorzugsweise die Haftverbindung durch Klebeeigenschaften zumindest einer der Leiterplatte zugewandten Oberfläche des Fixierelements, d.h. durch Adhäsion, vorgesehen wird.

Die Bauteile werden auf das Fixierelement aufgebracht bzw. auf diesem angeordnet, vorzugsweise nachdem das Fixierelement auf der Leiterplatte angeordnet bzw. befestigt wurde. Vorzugsweise weist das Fixierelement auch auf der dem Bauteil zugewandten Seite eine Oberfläche auf, die Klebeeigenschaften hat. Das Fixierelement kann insbesondere aus einem Klebemittel vorgesehen sein. Alternativ können auch Bauelement und/oder Leiterplatte eine Klebeschicht aufweisen, mit der das Fixierelement mit dem Bauelement und/oder mit der Leiterplatte verbunden wird. Das Fixierelement kann ferner zunächst mit dem Bauteil verbunden werden (durch Klebung), und das Bauteil wird zusammen mit dem darauf befestigten Fixierelement auf der Leiterplatte angeordnet bzw. befestigt.

Die Durchsteckkontakte werden in die dazu korrespondierenden Kontaktlöcher der Leiterplatte eingebracht durch Einstecken. Die Durchsteckkontakte werden insbesondere als Anschlussdrähte bzw. -pins vorgesehen. Die Durchsteckkontakte werden eingebracht, bevor das Fixierelement verformt wird. Dadurch bieten die Kontaktlöcher eine Führung für die Durchsteckkontakte, welche durch das Annähern von Bauelement und Leiterplatte unter Verformung des Fixierelements weiter in die korrespondierenden Kontaktlöcher eingebracht werden. Der Querschnitt der Kontaktlöcher ist vorzugsweise größer als der Querschnitt der Durchsteckkontakte, um eine lockere Führung zu ermöglichen. In oder an den Kontaktlöchern sind leitende Flächen zum späteren elektrischen Verbinden der Durchsteckkontakte vorgesehen, die ebenso leitende Außenflächen aufweisen und insbesondere als Drähte ausgebildet sind.

Eine ebene Oberfläche verschiebt die Wärmekontaktflächen der Bauteile zu der Leiterplatte hin, unter plastischer Verformung des Fixierelements. Die plastische Verformung nimmt die Verschiebung der Bauteile individuell für jedes Bauteil auf. Die Verschiebung wird ausgeführt, bis alle Wärmeabgabeflächen der Bauteile in derselben Ebene liegen. Gegebenenfalls werden die Bauteile der Leiterplatte noch weitergehend angenähert, wobei alle Bauteile um die gleiche Distanz zur Leiterplatte angenähert werden, um einen gewünschten Abstand zwischen der Ebene, in der die Bauteile liegen, und der Leiterplatte zu erreichen. Wie bereits bemerkt entspricht die ebene Form der Oberfläche der ebenen Form einer später anzubringenden Wärmeaufnahmefläche eines Kühlkörpers, wobei die Oberfläche jedoch auch andere Verläufe - neben dem ebenen Verlauf - haben kann, entsprechend der Wärmeaufnahmefläche des Kühlkörpers.

Ferner können die Bauteile parallel zur Wärmeabgabefläche aus dem Bauteil austretende Drähte aufweisen, die die Durchsteckkontakte bilden. Die Drähte sind entweder mit einer Krümmung von 90° von der Wärmeabgabefläche weg vorgesehen, oder die Drähte werden mit einer Krümmung von 90° von der Wärmeabgabefläche weg gebogen. Die Bauteile können dadurch zu der Leiterplatte hin verschoben werden, während die Durchsteckkontakte den entstehenden Versatz dadurch kompensieren, dass sie beim Ausrichten um eine zusätzliche Strecke tiefer in die Kontaktlöcher der Leiterplatte eingebracht werden.

Ferner können die Bauteile senkrecht zur Wärmeabgabefläche aus dem Bauteil austretende Drähte aufweisen, die die Durchsteckkontakte bilden und die sich von dem Bauteil und der Wärmeabgabefläche weg erstrecken. Hierbei sind die Drähte entweder ohne Krümmung vorgesehen, oder die Drähte werden gebogen, um einen Drahtendabschnitt zu bilden, der sich senkrecht von der Wärmeabgabefläche weg erstreckt. Hierbei treten die Drähte vorzugsweise aus derjenigen Seite des Bauteils senkrecht aus, die entgegengesetzt zur Wärmeabgabefläche ist.

Es können daher Bauteile verwendet werden, deren Anschlussdrähte (=Durchsteckkontakte) an der Unterseite des Bauteils (d.h. entgegengesetzt zur Wärmeabgabefläche und der Leiterplatte zugewandt) austreten, vorzugsweise senkrecht, oder es können Bauteile verwendet werden, die an einer Seitenfläche (senkrecht bzw. geneigt zur Leiterplatte bzw. der Wärmeabgabefläche) des Bauteils austreten. Im letztgenannten Fall werden die Durchsteckkontakte zu der Leiterplatte hin gebogen (mit einem Winkel von 90°) oder weisen bereits bei der Herstellung des Bauteils diese Krümmung auf.

Weiterhin werden die Durchsteckkontakte elektrisch mit Leiterplattenkontakten verbunden, die auf der Seite der Leiterplatte ausgebildet werden, die dem Bauteil abgewandt ist, oder die auf der Seite der Leiterplatte ausgebildet werden, die dem Bauteil zugewandt ist, oder die innerhalb der Kontaktlöcher ausgebildet werden. Insbesondere können die unterschiedlich angeordneten Leiterplattenkontakte miteinander kombiniert werden. Bei realen Anwendungen kommt bevorzugt eine Kombination der drei genannten Leiterplattenkontakt-Arten zum Einsatz: Eine Bohrung mit metallisierter Wandung, die auf beiden Leiterplatten-Außenseiten elektrisch mit einem Lötauge verbunden ist. Die Leiterplattenkontakte werden vorgesehen durch eine leitende Schicht, insbesondere eine Schicht aus Cu, Al oder einem anderen leitenden Material, Metall, oder Legierung, die strukturiert ist und beispielsweise Lötaugen ausbildet. Die Leiterplattenkontakte können durch photolithographische Ätzverfahren ausgebildet sein, durch Fräsen, durch Laserabtragung oder durch ähnliches. Die Durchsteckkontakte werden mit den Leiterplattenkontakten elektrisch verbunden durch Herstellen einer elektrisch leitenden stoffschlüssigen Verbindung, insbesondere durch Löten. Hierbei können Reflow-Lötverfahren verwendet werden, bzw. Lötverfahren, bei denen eine Lötpaste an einer Leiterplattenoberseite (oder insbesondere auf einer Innenseite der Kontaktlöcher) aufgebracht wird. Die Lötpaste wird auf die Leiterplattenkontakte aufgebracht. Die Durchsteckkontakte werden in die Kontaktlöcher eingebracht und durch Erwärmen wird das Lot verflüssigt; nach dem Abkühlen sind die Durchsteckkontakte mit den Leiterplattenkontakten elektrisch verbunden. Anstatt von Lötpaste kann auch Lötdraht verwendet werden, der in bekannter Weise verarbeitet wird, um die Durchsteckkontakte mit der Leiterplatte dauerhaft und leitend zu verbinden. Das Lotmaterial wird insbesondere in die Kontaktlöcher eingebracht, vorzugsweise in ein dort vorhandenes Depot, um ausreichend Lot zur Herstellung der Lötverbindung bereitzustellen.

Ferner ist erfindungsgemäß vorgesehen, dass das Fixierelement als eine durchgehende Fixierschicht oder in Form mehrerer Fixierelemente oder in Form zumindest eines Fixiermaterialstrangs aus einem Fixiermaterial aufgebracht wird. Bevorzugt wird das Material des Fixierelements auf die Leiterplatte aufgespritzt als Punkte oder als Strang. Das Material des Fixierelements kann ferner durch Stempeln, Dispensen oder Rakeln aufgebracht werden. Das Material kann durch eine Schablone hindurch aufgetragen werden, die auf der Leiterplatte angeordnet wird, und die nach dem Auftragen entfernt wird. Es ergeben sich präzise Anordnungsmuster.

Eine erste Alternative sieht vor, dass das aufgebrachte Fixiermaterial eine plastische Verformbarkeit aufweist, die mit steigender Temperatur zunimmt. Beispielsweise bei Verwendung eines thermoplastischen Materials mit einer Glasübergangstemperatur oder mit einem Glasübergangsbereich als Material für das Fixierelement wird die plastische Verformbarkeit des Fixierelements deutlich erhöht. Durch die Erwärmung erhält das Fixierelement eine Temperatur knapp unterhalb der Glasübergangstemperatur oder dem Glasübergangsbereich, vorzugsweise ca. 2 °C - 50 °C unterhalb. Ferner kann das Fixierelement auf die Glasübergangstemperatur bzw. auf eine Temperatur innerhalb des Glasübergangsbereichs erwärmt werden. Weiterhin kann das Fixierelement durch erwärmen aufgeschmolzen werden. Während die Verformbarkeit durch eine derartige Erwärmung erhöht ist, wird das Fixierelement durch Annährung der Bauelemente und Leiterplatte zueinander verformt. Das mindestens eine Fixierelement wird erwärmt, um die Verformung des Fixierelements zu unterstützen, während dieses plastisch verformt wird. Nach dem Verschieben der Bauteile und nach dem Verformen des Fixierelements, wird die Verformbarkeit wieder herabgesetzt durch Abkühlen des Fixierelements. Dadurch werden die Bauteile in angenäherter Position fixiert. Die Erwärmung zur Erhöhung der plastischen Verformbarkeit kann vorgesehen werden durch eine Erwärmung, mit der auch Lotmaterial geschmolzen wird, um die Durchsteckkontakte mit der Leiterplatte elektrisch mittels Lötverbindung zu verbinden.

Eine zweite, bevorzugte Alternative sieht vor, dass das aufgebrachte Fixiermaterial durch Erwärmen nach dem plastischen Verformen des Fixierelements ausgehärtet wird. Das Fixiermaterial, welches mindestens ein Fixierelement vorsieht, weist eine plastische Verformbarkeit auf, die durch das Erwärmen signifikant verringert wird. Das Fixiermaterial kann einen Klebstoff umfassen, der sich durch Wärme verfestigt, beispielsweise ein lösemittelhaltiger Klebstoff, Kontaktklebstoff oder wasserbasierter Klebstoff oder andere physikalisch abbindende Klebstoffe, die sich bei Erwärmung verfestigen, oder ein chemisch aushärtender Ein-oder Mehrkomponentenklebstoff, der sich beispielsweise durch Polymerisation oder durch andere chemische Verlinkungen verfestigt. Als weiteres Beispiel kann ein durch UV-Strahlung aushärtender Klebstoff verwendet werden, wobei zur Verfestigung nach dem Anordnen der Bauteile an die Zielposition das Fixierelement mit UV-Strahlung ausgehärtet wird. Das Material des Fixierelements verliert die strukturelle Integrität nicht, wenn die Schaltung während eines Lötprozesses erwärmt wird. Die Temperaturen ergeben sich aus der maximalen Belastungstemperatur der Bauelemente und der Dauer des Lötprozesses.

Die Erfindung betrifft ferner eine elektrische Schaltung mit einer Leiterplatte, bei der die elektronischen Bauteile durch mindestens ein plastisch verformbares Fixierelement mit der Leiterplatte verbunden sind, wobei die Wärmeabgabeflächen miteinander fluchten, da das Fixierelement, das entsprechend plastisch verformt ist, die unterschiedlichen Bauteildicken kompensiert.

Gemäß einem weiteren Aspekt wird die Oberfläche mit einer Gewichtskraft, Federkraft, pneumatischen Kraft oder hydraulischen Kraft beaufschlagt. Diese wird an mindestens eines der Bauteile (d.h. mindestens an das am weitesten herausragende Bauteil) über die Wärmeabgabefläche(n) übertragen. Das Bauteil überträgt eine resultierende Kraft auf das Fixierelement. Die übertragene Kraft erzeugt eine plastische Verformung des Fixierelements. Als ein Hauptmerkmal der Verformung wird die Dicke des Fixierelements zwischen Bauteil und Leiterplatte verringert. Die Annäherung der Oberfläche zu der Leiterplatte wird auf einen minimalen Abstand beschränkt wird, indem in dieser Richtung die Bewegungsfreiheit der Oberfläche auf eine Minimaldistanz zwischen Oberfläche und Leiterplatte beschränkt wird. Die Beschränkung wird vorgesehen beispielsweise mittels eines Abstandhalters, wobei der minimale Abstand, ab dem die Beschränkung greift, mindestens so groß ist wie die Dicke des dicksten Bauteils, vorzugsweise einschließlich einer vorgegebene Toleranzstreckenlänge und/oder einer zusätzlichen vorgegebenen Minimaldicke des Fixierelements. Als Verschiebung der Wärmeflächen zu der Leiterplatte hin wird allgemein die Annäherung von Leiterplatte und Wärmeflächen bezeichnet.

Die Oberfläche wird von einem starren Anordnungskörper (vorzugsweise aus einem hitzebeständigen Material) vorgesehen, der ferner vorzugsweise zusätzlich Abstandshalter umfasst, die den Minimalabstand zwischen Oberfläche und Leiterplatte definieren, und eine weitergehende Annäherung von Bauelementen und Leiterplatte blockieren, indem die Anordnungskörper die ausgeübte Kraft über die Abstandshalter auf die Leiterplatte (oder eine Leiterplattenhalterung) ableiten, wenn der Abstandshalter die Leiterplatte (oder einen anderen Anschlag) erreicht.

Eine besonders einfach umzusetzende Ausführung des Verfahrens sieht vor, dass die Wärmeabgabenflächen der Bauteile zu der Leiterplatte hin verschoben werden, indem eine Pressvorrichtung, die eine entsprechende Oberfläche vorsieht, auf die Wärmeabgabeflächen der Bauteile aufgelegt wird. Die Pressvorrichtung weist eine Gewichtskraft auf, die zum plastischen Verformen des mindestens einen Fixierelements ausreichend ist. Die Pressvorrichtung entspricht dem Anordnungskörper. Diese Ausführung sieht vor, dass Leiterplatte, Fixierelement, Bauteile und Pressvorrichtung in dieser Reihenfolge gestapelt sind in eine Richtung entgegen der Gravitation. Wenn die Pressvorrichtung aufgelegt ist, kann die gesamte Anordnung erwärmt werden, beispielsweise in einem Ofen, vorzugsweise einem Lötofen. Die Pressvorrichtung wird abgenommen, wenn das Material des Fixierelements zumindest teilweise ausgehärtet ist.

Weiterhin ist vorgesehen, dass das plastische Verformen ausgeführt wird, während die Leiterplatte, die Bauteile und das mindestens eine Fixierelement in einem Ofen angeordnet sind. Die Erwärmung des Fixierelements mittels des Ofens verringert die Viskosität des Fixierelements signifikant. Das Fixierelement wird dadurch erweicht. Das Fixierelement weist vorzugsweise thermoplastische Eigenschaften auf. Die Ofentemperatur kann sich an der Glasübergangstemperatur des Fixierelements orientieren. Während dem plastischen Verformen kann auch Lötpaste aufgeschmolzen werden, um beide Verfahrensschritte (plastisches Verformen des Fixierelements, elektrisches Kontaktieren der Bauelemente) gleichzeitig auszuführen.

Ferner umfasst das Aufbringen der Bauteile auf das mindestens eine Fixierelement vorzugsweise das Fixieren der Bauteile auf dem Fixierelement durch Klebeeigenschaften des Fixierelements. Die Klebeeigenschaften werden von der Oberfläche des Fixierelements vorgesehen, die den Bauteilen zugewandt ist. Ferner kann das Fixierelement auf die Leiterplatte geklebt werden durch Klebeeigenschaften der Oberfläche des Fixierelements, die der Leiterplatte zugewandt ist.

Schließlich werden gemäß einer Ausführungsform des Verfahrens die Bauteile an der Leiterplatte durch Aushärten des Fixierelements mittels Abkühlen oder durch Erwärmung befestigt, abhängig von dem Aushärteverhalten des Fixierelements. Die Bauteile werden befestigt, nachdem die Wärmeabgabeflächen der Bauteile in derselben Ebene unter plastischer Verformung des Fixierelements angeordnet wurden und somit ihre Zielposition erreicht haben. Nach dem Befestigen der Bauteile wird ein gemeinsames Kühlelement mit einer ebenen Wärmeaufnahmefläche (oder einem der Oberfläche entsprechenden Verlauf) auf die miteinander fluchtenden Wärmeabgabeflächen der Bauteile montiert. Hierbei wird ein wärmeleitender Kontakts zwischen den Wärmeabgabeflächen der Bauteile und der Wärmeaufnahmefläche des Kühlelements hergestellt, vorzugsweise unter Zuhilfenahme einer (dünnen) Schicht eines Wärmeleitmediums.

Die Erfindung sieht ferner eine Schaltung vor, die gemäß dem erfindungsgemäßen Verfahren bestückt ist. Eine derartige elektrische Schaltung weist eine Leiterplatte und darauf montierte, mehrere Bauteile auf, die (herstellungbedingt oder typbedingt) unterschiedliche Dicken haben. Die Bauteile weisen Wärmeabgabeflächen auf einer der Leiterplatte abgewandten Seite der Leiterplatte auf. Die Bauteile weisen ferner Durchsteckkontakte auf, die senkrecht zu den Wärmeabgabeflächen verlaufen. Die Leiterplatte weist korrespondierende Kontaktlöcher auf, durch die sich hindurch die Durchsteckkontakte erstrecken, welche an den Kontaktlöchern mit der Leiterplatte elektrisch kontaktiert sind. Zwischen der Leiterplatte und den Bauteilen erstreckt sich mindestens ein Fixierelement aus einem plastisch verformbaren Fixiermaterial. Das mindestens eine Fixierelement sieht eine mechanische Verbindung zwischen den Bauteilen und der Leiterplatte vor. Das Fixierelement ist vorzugsweise als eine durchgehende Fixierschicht oder in Form mehrerer Fixierelemente oder in Form zumindest eines Fixiermaterialstrangs ausgebildet. Das Fixierelement gleicht ferner die unterschiedlichen Dicken der Bauteile derart aus, dass der Abstand zwischen den Wärmeabgabeflächen und der Leiterplatte für alle Bauteile im Wesentlichen gleich ist. Dadurch liegen die Wärmeabgabeflächen in einer gemeinsamen Ebene. Diese gemeinsame Ebene bildet eine Kontaktebene geeignet zur Anordnung einer gemeinsamen ebenen Kühlkörperfläche. Alternativ kann die Schaltung auch zumindest einen Kühlkörper umfassen, dessen Wärmeaufnahmefläche mit mehreren Wärmeabgabeflächen (mehrerer Bauteile) in wärmeübertragendem Kontakt steht.

Als plastisch verformbares Fixiermaterial wird Material bezeichnet, das in einem Zustand vorgesehen werden kann, in dem eine plastische Verformung mit den hier beschriebenen Mitteln möglich ist. Das Fixiermaterial kann daher ab einer gewissen Temperatur diesen Zustand der dauerhaften Verformbarkeit (=plastische Verformung) aufweisen (in Sinne eines Thermoplasts) oder kann diesen Zustand aufweisen, bevor es durch Erwärmung oder anderweitige Aushärtung verfestigt ist, wenn ein Klebstoff als Fixiermaterial verwendet wird.

### Kurze Beschreibung der Zeichnungen

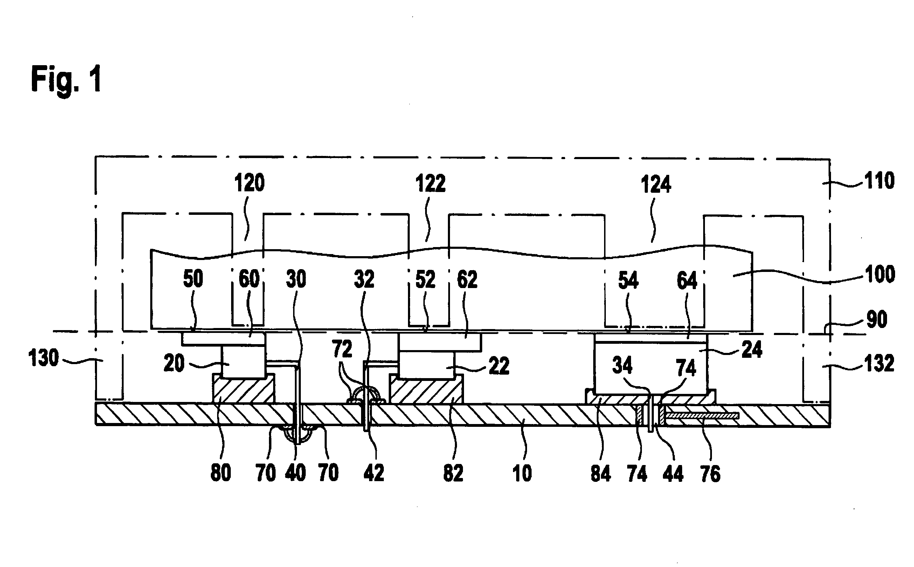

Figur 1 zeigt eine erfindungsgemäße elektrische Schaltung, die auch zur Erläuterung des erfindungsgemäßen Verfahrens verwendet wird.

### Ausführungsformen der Erfindung

Figur 1 zeigt eine erfindungsgemäße elektrische Schaltung mit einer Leiterplatte 10, beispielsweise eine Epoxy-Leiterplatte, die mit mehreren Bauelementen 20, 22, 24 bestückt ist. Die Bauelelemente weisen Durchsteckkontakte 30, 32, 34 auf, deren Endabschnitte in zugehörigen Kontaktlöchern 40, 42, 44 eingesteckt sind. Die Bauelelemente 20, 22, 24 sind mit Wärmeabgabeflächen 50, 52, 54 ausgestattet, die von jeweiligen Kühlfahnen 60, 62, 64 gebildet werden. Zu Bauformen, bei denen die Kühlfahnen auf der zur Leiterplatte entgegengesetzten Seite angeordnet sind, zählen insbesondere Bauformen zur sogenannten Slug-Up-Montage, bei denen das Kühlfahnenblech auf einer Seite des inneren Bauelements angeordnet ist, beispielsweise ein Halbleiterchip, während die elektrische Kontaktierungsebene auf der dazu entgegengesetzten Seite des inneren Bauelements liegt. Als wärmeerzeugende Bauelemente kommen insbesondere Endstufenbauteile, Leistungshalbleiter oder andere Bauteile mit hoher Verlustleistung in Frage, sowie getaktete Bauelemente wie Controller, CPU o.ä., die ebenso eine beträchtliche Menge an abzuführender Wärme erzeugen.

Die Leiterplatte 10 umfasst ferner Leiterplattenkontakte 70, 72, 74 aus leitendem und lötbarem Material. Die Leiterplattenkontakte 70, 72 sind als Oberflächen-Lötaugen ausgebildet, die auf einer Unterseite bzw. einer Oberseite der Leiterplatte 10 angeordnet sind. Der Leiterplattenkontakt 74 ist als innere Kontaktfläche in Kontaktloch 44 ausgebildet. In einer realen Anwendungen sind die Leiterplattenkontakte meist als Kombination aller drei genannten Ausführungen 70, 72 und 74 ausgeführt, d.h. eine Bohrung, deren Wandung metallisiert ist, und auf jeder der beiden Außenlagen der Leiterplatte ein Lötauge, das mit dieser metallisierten Wandung elektrisch leitend verbunden ist. Der Verlauf der Außenflächen der Lötaugen auf den Kontakte 70, 72 sind mit einem Doppelstrich dargestellt. Zwischen den Leiterplattenkontakten 70 - 74 und den zugehörigen Durchsteckkontakten 30, 32, 34 bzw. deren Enden ist eine Lötverbindung vorgesehen, die entweder oberflächig ist, siehe an Leiterplattenkontakten 70, 72, oder innerhalb der Leiterplatte 10 vorgesehen ist, oder oberflächig und innerhalb der Leiterplatte. Die Leiterplattenkontakte sind mit einem Anschluss oder mit mehreren Anschlüssen verbunden, beispielsweise einer äußeren Leiterbahn oder einer inneren Leiterbahn 76, oder zwei äußeren Leiterbahnen, oder zwei äußeren und einer oder mehrerer inneren Leiterbahnen, abhängig vom Aufbau der Leiterplatte und von der geforderten Stromtragfähigkeit des jeweiligen Anschlusses.

Die Bauelemente 20 und 22 weisen als Durchsteckkontakte 30, 32 Drähte auf, die seitlich aus dem Bauteil heraus treten und eine Krümmung aufweisen, um sich senkrecht in das betreffende Kontaktloch 40, 42 hinein zu erstrecken. Das Bauelement 24 weist als Durchsteckkontakt zumindest einen Draht 34 auf, der auf der Unterseite des Bauteils aus diesem heraustritt und ohne Krümmung sich in das betreffende Kontaktloch 44 hinein erstreckt. Dadurch unterscheidet sich Bauteil 24 von den Bauteilen 20 - 22.

Ferner unterscheiden sich die Bauteile 20 - 24 hinsichtlich der Dicke der Lötfahne und somit auch hinsichtlich der Gesamtdicke. Die Unterscheidung ergibt sich durch unterschiedliche Bauformen (vgl. 20 und 24) sowie durch Streuung bzw. Toleranzen bei der Herstellung (vgl. 20 und 22).

Um diese unterschiedlichen Proportionen, deren Unterschiede in Figur 1 stark vergrößert dargestellt sind, zu kompensieren sind Fixierelemente 80 - 84 vorgesehen, die unterschiedlich stark eingedrückt sind. Bevorzugt wird pro Bauelement nicht nur ein einzelnes Fixierelement verwendet, wie in Figur 1 der besseren Übersicht wegen dargestellt ist, sondern es werden mehrere Fixierelemente in Form von einzelnen Klebepunkten pro Bauteil verwendet. Mit den Fixierelementen 80 - 84 wird erreicht, dass alle Wärmeabgabeflächen 50 - 54 in derselben Ebene 90 vorliegen. In dieser Ebene erstreckt sich auch eine ebene Wärmeaufnahmefläche eines Kühlkörpers 100.

Im Rahmen des erfindungsgemäßen Verfahrens wird zunächst die Leiterplatte 10 mit Kontaktlöchern 40 - 44 vorgesehen sowie mit Leiterplattenkontakten 70 - 74. Die Kontaktlöcher sind gebohrte und an der Wandung metallisierte Durchgangslöcher. Dann wird das Fixierelement 80 - 84 aufgebracht, insbesondere in Form eines Fixierklebers, beispielsweise durch Dispensen, Stempeln, Spritzen und/oder Rakeln. Es folgt das Bestücken (d.h. Anordnen) der Bauelemente 60 - 64 auf die Fixierelemente 80 - 84 sowie das gleichzeitige Durchstecken der Durchsteckkontakte 30 - 34 in bzw. durch die Kontaktlöcher 40 - 44. Ein Anordnungskörper 110, strichpunktiert dargestellt, sieht für jedes Bauelement 20 - 24 einen Arm 120 - 124 vor, wobei deren Unterseiten zusammen die Oberfläche vorsehen, mit der der Druck auf die Bauelemente 20 - 24 ausgeübt wird, um diese in die Fixierelemente 80 - 84 zu drücken, die sich daraufhin plastisch verformen. Der Anordnungskörper 110 umfasst ferner Abstandshalter 130, 132, die länger als die Arme 120 -124 sind, und die die Annährung von Anordnungskörper 110 und Leiterplatte 130 begrenzen. Die Unterseiten der Arme 120 - 124 erstrecken sich entlang der selben Ebene 90, gestrichelt dargestellt.

Daraufhin wird der Anordnungskörper 110 wieder abgenommen. Nach dem Herstellen der elektrischen Verbindungen z.B. durch Löten wird der Kühlkörper 100 auf Wärmeabgabeflächen 50 - 54 montiert, die sich in der Ebene 90 befinden. Der Abstand zwischen den Wärmeabgabeflächen 50 - 54 der Bauteile und dem Kühlkörper ist daher für jedes Bauelement gleich, da unterschiedliche Dicken von der Verformung der Fixierelemente 80 - 84 kompensiert worden sind. In einer bevorzugten Umsetzung entsprechen diese Abstände der Dicke des Wärmeleitmediums, das sich dazwischen erstreckt.

## Patentansprüche

1. Verfahren zur Bestückung einer Leiterplatte (10) mit mehreren Bauteilen (20, 22, 24), mit den Schritten: Vorsehen der Bauteile (20, 22, 24) mit Durchsteckkontakten (30, 32, 34), die sich zumindest in Endabschnitten der Durchsteckkontakte (30, 32, 34) in einer Richtung senkrecht zu den Wärmeabgabenflächen (50, 52, 54) der Bauteile (20, 22, 24) erstrecken, Vorsehen der Leiterplatte (10) mit Kontaktlöchern (40, 42, 44) zur Aufnahme von Durchsteckkontakten (30, 32, 34),
**gekennzeichnet durch**
Aufbringen mindestens eines plastisch verformbaren Fixierelements (80, 82, 84) auf die Leiterplatte (10), Aufbringen der Bauteile (20, 22, 24) auf das Fixierelement (80, 82, 84) und gleichzeitiges Einbringen der Durchsteckkontakte (30, 32, 34) in die dazu korrespondierenden Kontaktlöcher (40, 42, 44) der Leiterplatte (10); wobei eine ebene Oberfläche, insbesondere eines Anordnungskörpers (110), die Wärmeabgabeflächen (50, 52, 54) der Bauteile (20, 22, 24) zu der Leiterplatte (10) hin verschiebt, unter plastischer Verformung des Fixierelements, bis alle Wärmeabgabeflächen (50, 52, 54) der Bauteile (20, 22, 24) in der selben Ebene (90) liegen.

2. Verfahren nach Anspruch 1, wobei die Bauteile (20, 22) parallel zur Wärmeabgabefläche (50, 52) aus dem Bauteil (20, 22) austretende Drähte aufweisen, die die Durchsteckkontakte (30, 32) bilden und die Drähte entweder mit einer Krümmung von 90° von der Wärmeabgabefläche (50, 52) weg vorgesehen sind, oder die Drähte mit einer Krümmung von 90° von der Wärmeabgabefläche weg gebogen werden, oder wobei die Bauteile senkrecht zur Wärmeabgabefläche (54) aus dem Bauteil (24) austretende Drähte aufweisen, die die Durchsteckkontakte (34) bilden und die sich von dem Bauteil (24) und der Wärmeabgabefläche (54) weg erstrecken, wobei die Drähte entweder ohne Krümmung vorgesehen sind, oder die Drähte gebogen werden, um einen Drahtendabschnitt zu bilden, der sich senkrecht von der Wärmeabgabefläche (54) weg erstreckt.

3. Verfahren nach Anspruch 1 oder 2, wobei die Durchsteckkontakte (30) mit Leiterplattenkontakten (70) elektrisch verbunden werden, die auf der Seite der Leiterplatte (10) ausgebildet werden, die dem Bauteil (20) abgewandt ist, oder mit Leiterplattenkontakten (72) verbunden werden, die auf der Seite der Leiterplatte (10) ausgebildet werden, die dem Bauteil (22) zugewandt ist, oder mit Leiterplattenkontakten (74) innerhalb der Kontaktlöcher (44) verbunden werden, oder eine Kombination hiervon, wobei die Durchsteckkontakte (30, 32, 34) mit Leiterplattenkontakten (70, 72, 74) elektrisch verbunden werden durch Herstellen einer elektrisch leitenden stoffschlüssigen Verbindung, insbesondere durch Löten.

4. Verfahren nach einem der vorangehenden Ansprüche, wobei das Fixierelement (80, 82, 84) als eine durchgehende Fixierschicht oder in Form mehrerer Fixierelemente (80, 82, 84) oder in Form zumindest eines Fixiermaterialstrangs aus einem Fixiermaterial aufgebracht wird, wobei das aufgebrachte Fixiermaterial eine plastische Verformbarkeit ausweist, die mit steigender Temperatur zunimmt und das mindestens eine Fixierelement (80, 82, 84) erwärmt wird, um die Verformung des Fixierelements zu unterstützen, während dieses plastisch verformt wird, und nach dem Verschieben der Bauteile (20, 22, 24) und nach dem Verformen des Fixierelements (80, 82, 84), dieses wieder zum mechanischen Fixieren der Bauteile (20, 22, 24) abgekühlt wird, oder wobei das aufgebrachte Fixiermaterial durch Erwärmen nach dem plastischen Verformen des Fixierelements (80, 82, 84) ausgehärtet wird und eine plastische Verformbarkeit ausweist, die durch das Erwärmen signifikant verringert wird.

5. Verfahren nach einem der vorangehenden Ansprüche, wobei die Oberfläche mit einer Gewichtskraft, Federkraft, pneumatischen Kraft oder hydraulischen Kraft beaufschlagt wird, die diese an mindestens eines der Bauteile (20, 22, 24) über die Wärmeabgabefläche (50, 52, 54) überträgt, wodurch das Bauteil eine Kraft auf das Fixierelement (80, 82, 84) überträgt, die eine plastische Verformung des Fixierelements (80, 82, 84) unter Verringerung der Dicke des Fixierelements (80, 82, 84) zwischen Bauteil (20, 22, 24) und Leiterplatte (10) erzeugt, wobei die Annäherung der Oberfläche zu der Leiterplatte (10) auf einen minimalen Abstand beschränkt wird, beispielsweise mittels eines Abstandhalters (130, 132), wobei der Abstand mindestens so groß ist wie die Dicke des dicksten Bauteils (24).

6. Verfahren nach einem der vorangehenden Ansprüche, wobei die Wärmeabgabeflächen (50, 52, 54) der Bauteile (20, 22, 24) zu der Leiterplatte (10) hin von der Oberfläche verschoben werden, indem eine Pressvorrichtung (110), die die Oberfläche vorsieht, auf die Wärmeabgabeflächen (50, 52, 54) der Bauteile (20, 22, 24) aufgelegt wird, wobei die Pressvorrichtung (110) eine Gewichtskraft aufweist, die zum plastischen Verformen des mindestens einen Fixierelements (80, 82, 84) ausreichend ist.

7. Verfahren nach einem der vorangehenden Ansprüche, wobei das plastische Verformen ausgeführt wird, während die Leiterplatte (10), die Bauteile (20, 22, 24) und das mindestens eine Fixierelement (80, 82, 84) in einem Ofen angeordnet sind und die Erwärmung des Fixierelements (80, 82, 84) mittels des Ofens die Viskosität des Fixierelements signifikant verringert.

8. Verfahren nach einem der vorangehenden Ansprüche, wobei das Aufbringen der Bauteile (20, 22, 24) auf das mindestens eine Fixierelement (80, 82, 84) umfasst: Fixieren der Bauteile (20, 22, 24) auf dem Fixierelement (80, 82, 84) durch Klebeeigenschaften des Fixierelements (80, 82, 84), insbesondere einer Oberfläche des Fixierelements (80, 82, 84), die den Bauteilen (20, 22, 24) zugewandt ist.

9. Verfahren nach einem der vorangehenden Ansprüche, ferner umfassend: Befestigen der Bauteile (20, 22, 24) an der Leiterplatte (10) durch Aushärten des Fixierelements (80, 82, 84) mittels Abkühlen oder durch Erwärmung, nachdem die Wärmeabgabeflächen (50, 52, 54) der Bauteile (20, 22, 24) in der selben Ebene (90) unter plastischer Verformung des Fixierelements (80, 82, 84) angeordnet wurden, wobei nach dem Befestigen der Bauteile (20, 22, 24) ein gemeinsames Kühlelement (100) mit einer ebenen Wärmeaufnahmefläche auf die miteinander fluchtenden Wärmeabgabeflächen (50, 52, 54) der Bauteile (20, 22, 24) montiert wird unter Herstellung eines wärmeleitenden Kontakts zwischen den Wärmeabgabeflächen (50, 52, 54) der Bauteile (20, 22, 24) und der Wärmeaufnahmefläche des Kühlelements (100).

10. Elektrische Schaltung mit einer Leiterplatte (10) und darauf montierten mehreren Bauteilen (20, 22, 24), die unterschiedliche Dicken haben und die Wärmeabgabeflächen (50, 52, 54) auf einer der Leiterplatte (10) abgewandten Seite aufweisen, wobei die Bauteile (20, 22, 24) Durchsteckkontakte (30, 32, 34) aufweisen, die zumindest in Endabschnitten der Durchsteckkontakte (30, 32, 34) senkrecht zu den Wärmeabgabenflächen (50, 52, 54) verlaufen, wobei die Leiterplatte (10) Kontaktlöcher (40, 42, 44) aufweist, durch die sich hindurch die Durchsteckkontakte (30, 32, 34) erstrecken, welche an den Kontaktlöchern (40, 42, 44) mit der Leiterplatte (10) elektrisch kontaktiert sind, **dadurch gekennzeichnet, dass** zwischen der Leiterplatte (10) und den Bauteilen mindestens ein Fixierelement (80, 82, 84) aus einem plastisch verformbaren Fixiermaterial erstreckt, wobei das mindestens eine Fixierelement (80, 82, 84) eine mechanische Verbindung zwischen den Bauteilen (20, 22, 24) und der Leiterplatte (10) vorsieht, und das Fixierelement (80, 82, 84) vorzugsweise als eine durchgehende Fixierschicht oder in Form mehrerer Fixierelemente (80, 82, 84) oder in Form zumindest eines Fixiermaterialstrangs ausgebildet ist, wobei das Fixierelement (80, 82, 84) ferner die unterschiedlichen Dicken der Bauteile (20, 22, 24) derart ausgleicht, dass der Abstand zwischen den Wärmeabgabeflächen (50, 52, 54) und der Leiterplatte (10) für alle Bauteile (20, 22, 24) im Wesentlichen gleich ist, wodurch die Wärmeabgabeflächen (50, 52, 54) in einer gemeinsamen Ebene (90) liegen, die eine Kontaktebene geeignet zur Anordnung einer gemeinsamen ebenen Kühlkörperfläche bildet.

## Claims

1. Method for populating a printed circuit board (10) having a plurality of components (20, 22, 24), comprising the steps of: providing the components (20, 22, 24) with plug-through contacts (30, 32, 34) which, at least in end sections of the plug-through contacts (30, 32, 34), extend in a direction perpendicular to the heat-emitting areas (50, 52, 54) of the components (20, 22, 24), providing the printed circuit board (10) with contact holes (40, 42, 44) for receiving plug-through contacts (30, 32, 34), **characterized by** fitting at least one plastically deformable fixing element (80, 82, 84) onto the printed circuit board (10), fitting the components (20, 22, 24) onto the fixing element (80, 82, 84) and at the same time inserting the plug-through contacts (30, 32, 34) into the corresponding contact holes (40, 42, 44) in the printed circuit board (10); wherein a planar surface, in particular of an arrangement body (110), moves the heat-emitting areas (50, 52, 54) of the components (20, 22, 24) in the direction of the printed circuit board (10), with plastic deformation of the fixing element, until all of the heat-emitting areas (50, 52, 54) of the components (20, 22, 24) lie in the same plane (90).

2. Method according to Claim 1, wherein the components (20, 22) have wires which protrude from the component (20, 22) parallel to the heat-emitting area (50, 52) and which form the plug-through contacts (30, 32), and the wires are provided either with a curvature of 90° away from the heat-emitting area (50, 52), or the wires are bent away from the heat-emitting area with a curvature of 90°, or wherein the components have wires which protrude from the component (24) perpendicular to the heat-emitting area (54), which form the plug-through contacts (34) and which extend away from the component (24) and the heat-emitting area (54), wherein the wires are either provided without a curvature, or the wires are bent in order to form a wire end section which extends away from the heat-emitting area (54) in a perpendicular manner.

3. Method according to Claim 1 or 2, wherein the plug-through contacts (30) are electrically connected to printed circuit board contacts (70) which are formed on that face of the printed circuit board (10) which is averted from the component (20), or are connected to printed circuit board contacts (72) which are formed on that face of the printed circuit board (10) which faces the component (22), or are connected to printed circuit board contacts (74) within the contact holes (44), or a combination of the above, wherein the plug-through contacts (30, 32, 34) are electrically connected to printed circuit board contacts (70, 72, 74) by establishing an electrically conductive cohesive connection, in particular by soldering.

4. Method according to one of the preceding claims, wherein the fixing element (80, 82, 84) is fitted as a continuous fixing layer or in the form of a plurality of fixing elements (80, 82, 84) or in the form of at least one fixing material section which is composed of a fixing material, wherein the fitted fixing material has a degree of plastic deformability which increases as the temperature rises and the at least one fixing element (80, 82, 84) is heated in order to assist deformation of the fixing element as it undergoes plastic deformation, and, after the components (20, 22, 24) are moved and after the fixing element (80, 82, 84) is deformed, the said fixing element is again cooled in order to mechanically fix the components (20, 22, 24), or wherein the fitted fixing material is cured by heating after the plastic deformation of the fixing element (80, 82, 84) and exhibits a degree of plastic deformability which is significantly reduced by the heating.

5. Method according to one of the preceding claims, wherein the surface is subjected to a weight force, spring force, pneumatic force or hydraulic force, the said force being transmitted by the surface to at least one of the components (20, 22, 24) via the heat-emitting area (50, 52, 54), as a result of which the component transmits a force to the fixing element (80, 82, 84) which generates plastic deformation of the fixing element (80, 82, 84) so as to reduce the thickness of the fixing element (80, 82, 84) between component (20, 22, 24) and printed circuit board (10), wherein the proximity of the surface to the printed circuit board (10) is restricted to a minimum distance, for example by means of a spacer (130, 132), wherein the distance is at least equal to the thickness of the thickest component (24).

6. Method according to one of the preceding claims, wherein the heat-emitting areas (50, 52, 54) of the components (20, 22, 24) are moved from the surface in the direction of the printed circuit board (10) by a pressing apparatus (110), which provides the surface, being placed onto the heat-emitting areas (50, 52, 54) of the components (20, 22, 24), wherein the pressing apparatus (110) has a weight force which is sufficient for plastically deforming the at least one fixing element (80, 82, 84).

7. Method according to one of the preceding claims, wherein the plastic deformation is executed while the printed circuit board (10), the components (20, 22, 24) and the at least one fixing element (80, 82, 84) are arranged in a furnace, and heating of the fixing element (80, 82, 84) by means of the furnace significantly reduces the viscosity of the fixing element.

8. Method according to one of the preceding claims, wherein fitting of the components (20, 22, 24) onto the at least one fixing element (80, 82, 84) comprises: fixing the components (20, 22, 24) onto the fixing element (80, 82, 84) by virtue of adhesive properties of the fixing element (80, 82, 84), in particular of a surface of the fixing element (80, 82, 84) which faces the components (20, 22, 24).

9. Method according to one of the preceding claims, further comprising: fastening the components (20, 22, 24) to the printed circuit board (10) by curing the fixing element (80, 82, 84) by means of cooling or by virtue of heating after the heat-emitting areas (50, 52, 54) of the components (20, 22, 24) have been arranged in the same plane (90) with plastic deformation of the fixing element (80, 82, 84), wherein, after fastening of the components (20, 22, 24), a common cooling element (100) with a planar heat-absorbing area is mounted onto the heat-emitting areas (50, 52, 54), which are in alignment with one another, of the components (20, 22, 24), so as to establish thermally conductive contact between the heat-emitting areas (50, 52, 54) of the components (20, 22, 24) and the heat-absorbing area of the cooling element (100).

10. Electrical circuit having a printed circuit board (10) and a plurality of components (20, 22, 24) which are mounted on the said printed circuit board and which have different thicknesses and which have heat-emitting areas (50, 52, 54) on a face which is averted from the printed circuit board (10), wherein the components (20, 22, 24) have plug-through contacts (30, 32, 34) which run perpendicular to the heat-emitting areas (50, 52, 54) at least in end sections of the plug-through contacts (30, 32, 34), wherein the printed circuit board (10) has contact holes (40, 42, 44) through which the plug-through contacts (30, 32, 34), with which electrical contact is made by the printed circuit board (10) at the contact holes (40, 42, 44), extend, **characterized in that** at least one fixing element (80, 82, 84) which is composed of a plastically deformable fixing material extends between the printed circuit board (10) and the components, wherein the at least one fixing element (80, 82, 84) provides a mechanical connection between the components (20, 22, 24) and the printed circuit board (10), and the fixing element (80, 82, 84) is preferably in the form of a continuous fixing layer or in the form of a plurality of fixing elements (80, 82, 84) or in the form of at least one fixing material section, wherein the fixing element (80, 82, 84) further compensates for the different thicknesses of the components (20, 22, 24) in such a way that the distance between the heat-emitting areas (50, 52, 54) and the printed circuit board (10) is substantially the same for all of the components (20, 22, 24), as a result of which the heat-emitting areas (50, 52, 54) lie in a common plane (90) which forms a contact plane which is suitable for the arrangement of a common planar heat sink area.

## Revendications

1. Procédé de placement de plusieurs composants (20, 22, 24) sur une carte de circuit (10), le procédé présentant les étapes qui consistent à :
doter les composants (20, 22, 24) de contacts enfichables (30, 32, 34), au moins les parties d'extrémité des contacts enfichables (30, 32, 34), s'étendant dans une direction perpendiculaire aux surfaces (50, 52, 54) émettrices de chaleur des composants (20, 22, 24),
doter la carte de circuit (10) de trous de contact (40, 42, 44) qui reprennent les contacts enfichables (30, 32, 34),
**caractérisé par** les étapes qui consistent à :
appliquer au moins un élément plastiquement déformable de fixation (80, 82, 84) sur la carte de circuit (10),
appliquer les composants (20, 22, 24) sur l'élément de fixation (80, 82, 84) et simultanément amener les contacts enfichables (30, 32, 34) dans les trous de contact correspondants (40, 42, 44) de la carte de circuit (10),
une surface plane et en particulier un corps de placement (110) déplaçant les surfaces (50, 52, 54) émettrices de chaleur des composants (20, 22, 24) vers la carte de circuit (10) en déformant plastiquement les éléments de fixation jusqu'à ce que toutes les surfaces (50, 52, 54) émettrices de chaleur des composants (20, 22, 24) soient situées dans le même plan (90).

2. Procédé selon la revendication 1, dans lequel les composants (20, 22) présentent des fils qui sortent du composant (20, 22) parallèlement à la surface (50, 52) émettrice de chaleur, ces fils formant les contacts enfichables (30, 32), les fils étant dotés d'une courbure de 90° par rapport à la surface (50, 52) émettrice de chaleur ou les fils étant courbés à une courbure de 90° par rapport à la surface émettrice de chaleur,
les composants présentant des fils qui sortent du composant (24) perpendiculairement à la surface (54) émettrice de chaleur et qui forment les contacts enfichables (34) et s'éloignent du composant (24) et de la surface (54) émettrice de chaleur, les fils étant prévus sans courbure ou les fils étant courbés pour former une section d'extrémité de fil qui s'éloigne perpendiculairement de la surface (54) émettrice de chaleur.

3. Procédé selon les revendications 1 ou 2, dans lequel les contacts enfichables (30) sont raccordés électriquement à des contacts (70) de la carte de circuit formés sur le côté de la carte de circuit (10) non tourné vers le composant (20), sont reliés à des contacts (72) de la carte de circuit qui sont formés sur le côté de la carte de circuit (10) tourné vers le composant (22) ou sont reliés à des contacts (74) de carte de circuit prévus à l'intérieur des trous de contact (44), ou avec une combinaison de ces caractéristiques, les contacts enfichables (30, 32, 34) étant raccordés électriquement à des contacts (70, 72, 74) de carte de circuit par établissement d'une liaison électriquement conductrice en correspondance de matière, en particulier par brasage.

4. Procédé selon l'une des revendications précédentes, dans lequel l'élément de fixation (80, 82, 84) est appliqué sous la forme d'une couche continue de fixation, sous la forme de plusieurs éléments de fixation (80, 82, 84) ou sous la forme d'au moins une barre de matériau de fixation constituée d'un matériau de fixation, le matériau de fixation appliqué présentant une aptitude à la déformation plastique qui augmente avec la température et le ou les éléments de fixation (80, 82, 84) étant chauffés pour soutenir la déformation de l'élément de fixation pendant que ce dernier est déformé plastiquement, ce dernier étant de nouveau refroidi pour fixer mécaniquement les composants (20, 22, 24) après le déplacement des composants (20, 22, 24) et après la déformation de l'élément de fixation (80, 82, 84), le matériau de fixation appliqué étant durci par chauffage après la déformation plastique de l'élément de fixation (80, 82, 84) et présentant une aptitude à la déformation plastique qui est significativement réduite par chauffage.

5. Procédé selon l'une des revendications précédentes, dans lequel la force d'un poids, une force élastique, une force pneumatique ou une force hydraulique sont appliquées sur la surface et sont transférées par cette dernière à au moins l'un des composants (20, 22, 24) par l'intermédiaire de la surface (50, 52, 54) émettrice de chaleur, grâce à quoi le composant transfère sur l'élément de fixation (80, 82, 84) une force qui provoque une déformation plastique de l'élément de fixation (80, 82, 84) qui diminue l'épaisseur de l'élément de fixation (80, 82, 84) entre le composant (20, 22, 24) et la carte de circuit (10), l'approche de la surface vers la carte de circuit (10) étant limitée à une distance minimale, par exemple au moyen d'un écarteur (130, 132), la distance étant au moins aussi grande que l'épaisseur du composant (24) le plus épais.

6. Procédé selon l'une des revendications précédentes, dans lequel les surfaces (50, 52, 54) émettrice de chaleur des composants (20, 22, 24) sont déplacées en direction de la carte de circuit (10) depuis la surface par le fait qu'un ensemble de poussée (110) qui prévoit la surface est appliqué sur les surfaces (50, 52, 54) émettrices de chaleur des composants (20, 22, 24), l'ensemble de poussée (110) présentant une force pondérale qui suffit pour déformer plastiquement le ou les éléments de fixation (80, 82, 84).

7. Procédé selon l'une des revendications précédentes, dans lequel la déformation plastique est réalisée pendant que la carte de circuit (10), les composants (20, 22, 24) et le ou les éléments de fixation (80, 82, 84) sont disposés dans un four, le chauffage de l'élément de fixation (80, 82, 84) au moyen du four diminuant de manière significative la viscosité de l'élément de fixation.

8. Procédé selon l'une des revendications précédentes, dans lequel l'application des composants (20, 22, 24) sur le ou les éléments de fixation (80, 82, 84) comporte l'étape qui consiste à fixer les composants (20, 22, 24) sur l'élément de fixation (80, 82, 84) par des propriétés adhésives de l'élément de fixation (80, 82, 84), en particulier d'une surface de l'élément de fixation (80, 82, 84) tournée vers les composants (20, 22, 24).

9. Procédé selon l'une des revendications précédentes, comprenant en outre l'étape qui consiste à :
fixer les composants (20, 22, 24) sur la carte de circuit (10) par durcissement de l'élément de fixation (80, 82, 84) au moyen d'un refroidissement ou d'un chauffage après que les surfaces (50, 52, 54) émettrices de chaleur des composants (20, 22, 24) ont été disposées dans le même plan (90) par déformation plastique de l'élément de fixation (80, 82, 84), tandis qu'après la fixation des composants (20, 22, 24), un élément de refroidissement (100) commun présentant une surface plane émettrice de chaleur est monté sur les surfaces (50, 52, 54) émettrices de chaleur, alignées les unes sur les autres, des composants (20, 22, 24) en établissant un contact thermoconducteur entre les surfaces (50, 52, 54) émettrices de chaleur des composants (20, 22, 24) et la surface de reprise de chaleur de l'élément de refroidissement (100).

10. Circuit électrique présentant une carte de circuit (10) sur laquelle sont montés plusieurs composants (20, 22, 24) qui présentent des épaisseurs différentes et qui présentent des surfaces (50, 52, 54) émettrices de chaleur sur un côté non tourné vers la carte de circuit (10), les composants (20, 22, 24) présentant des contacts enfichables (30, 32, 34) qui s'étendent, au moins dans des parties d'extrémité des contacts enfichables (30, 32, 34) perpendiculairement aux surfaces (50, 52, 54) émettrices de chaleur, la carte de circuit (10) présentant des trous de contact (40, 42, 44) par lesquels s'étendent les contacts enfichables (30, 32, 34) qui sont mis en contact électrique avec la carte de circuit (10) au niveau des trous de contact (40, 42, 44),
**caractérisé en ce que**
au moins un élément de fixation (80, 82, 84) en un matériau de fixation plastiquement déformable s'étend entre la carte de circuit (10) et les composants, le ou les éléments de fixation (80, 82, 84) établissant une liaison mécanique entre les composants (20, 22, 24) et la carte de circuit (10), l'élément de fixation (80, 82, 84) étant configuré de préférence comme couche continue de fixation, sous la forme de plusieurs éléments de fixation (80, 82, 84) ou sous la forme d'au moins une barre de matériau de fixation,
l'élément de fixation (80, 82, 84) compensant en outre les différentes épaisseurs des composants (20, 22, 24) de telle sorte que la distance entre les surfaces (50, 52, 54) émettrices de chaleur et la carte de circuit (10) soit essentiellement identique pour tous les composants (20, 22, 24), grâce à quoi les surfaces (50, 52, 54) émettrices de chaleur sont situées dans un plan (90) commun qui forme un plan de contact convenant pour placer une surface plane commune de corps de refroidissement.
